# EUROPEAN PATENT SPECIFICATION

(11) **EP 4 016 646 B1**
(45) Date of publication and mention of the grant of the patent: **12.08.2026**
(21) Application number: 20216094.1
(22) Date of filing: 21.12.2020
(51) Int. Cl.: H10D 30/63, H10D 30/01, H10D 62/832

(54) **POWER SEMICONDUCTOR DEVICE AND PRODUCTION METHOD**
LEISTUNGSHALBLEITERBAUELEMENT UND HERSTELLUNGSVERFAHREN
DISPOSITIF À SEMI-CONDUCTEUR DE PUISSANCE ET PROCÉDÉ DE PRODUCTION

(43) Date of publication of application: 22.06.2022
(73) Proprietor: Hitachi Energy Ltd, 8050 Zürich (CH)
(72) Inventor: WIRTHS, Stephan, 8800 Thalwil (CH); KNOLL, Lars, 5607 Hägglingen (CH); MIHAILA, Andrei, 5415 Rieden (CH)
(74) Representative: Epping - Hermann - Fischer

(56) References cited:
- WO-A1-01/11690
- WO-A1-2020/114666
- US-A- 5 323 040
- US-B1- 10 056 289

## Description

A power semiconductor device is provided. A production method for such a power semiconductor device is also provided.

Document US 2016/0351391 A1 refers to semiconductor nanowire production.

Document US 2011/0124169 A1 refers to methods of selectively depositing an epitaxial layer.

Document US 5 323 040 A refers to a silicon carbide field effect device that includes vertically stacked silicon carbide regions of first conductivity type, extending from a lowermost drain region to an uppermost source region. In between the drain and source regions, a drift region and a channel region are provided. The drift region extends adjacent the drain region and the channel region extends between the drift region and the source region. Control of majority carrier conduction between the source and drain regions is provided by a plurality of trenches, which extend through the source and channel region, and conductive gate electrodes therein. To provide high blocking voltage capability and low on-state resistance, the doping concentration in the drift region is selected to be greater than the doping concentration of the channel region but below the doping concentration of the drain and source regions. Preferably, the material used for the gate electrodes, the spacing between adjacent trenches and the doping concentration of the channel region are chosen so that the channel region is depleted of majority charge carriers when zero potential bias is applied to the gate electrodes.

Documents US 10 056 289 B1, WO 01/11690 A1 and WO 2020/114666 A1 refer to semiconductor devices.

A problem to be solved is to provide a power semiconductor device having a high efficiency.

Exemplary embodiments of the disclosure address the above shortcomings, by a power semiconductor device and by a production method as defined in the independent patent claims. Exemplary further developments constitute the subject matter of the dependent patent claims.

The power semiconductor device comprises a plurality of nano wires or micro wires, also referred to as pillars, made of a semiconductor material, and an accumulation channel is configured in the wires so that the wires can exclusively consist of material of the same conductivity type like n-type SiC.

Thus, the power semiconductor device comprises
- a first main electrode, for example, a continuous metallic layer,
- a second main electrode, for example, another continuous metallic layer,
- a semiconductor layer stack between the first main electrode and the second main electrode and optionally in direct contact with the first main electrode and the second main electrode, and
- a gate electrode layer between the first main electrode and the second main electrode, but electrically separated from the first main electrode and the second main electrode,
wherein
- the semiconductor layer stack comprises a plurality of pillars in contact with the first main electrode, the pillars are also referred to as nano wires or micro wires,
- the pillars run through the gate electrode layer, for example, completely through the gate electrode layer, also referred to as traversing the gate electrode layer,
- the whole semiconductor layer stack is of the same conductivity type, for example, of n-type, completely or in places from the first main electrode to the second main electrode, along directions perpendicular with a common plane,
- each one of the pillars comprises a top region at the first main electrode with a first doping concentration, the top region may be in direct contact with the first main electrode,
- at sides of the top regions facing away from the first main electrode, and in the common plane with the gate electrode layer, each of the pillars comprises a channel region with a second doping concentration, and
- the first doping concentration exceeds the second doping concentration by at least a factor of 5 or at least a factor of 10 or at least a factor of 50 or at least a factor of 200.

Thus, in the power semiconductor device described herein the grown semiconductor layer stack from the first main electrode to the second main electrode along directions perpendicular to the common plane exclusively consists of, for example, n-type SiC in order to realize, for example, a SiC AccuFET, that is, to an Accumulation Channel Field-Effect Transistor. The principal difference between an AccuFET using an accumulation-channel and a conventional metal-oxide semiconductor FET using an inversion channel is the presence of a thin n-channel region, that is, an accumulation-layer, below and/or next to a gate insulator. The thickness, length, and n-doping concentration of this accumulation-layer can be carefully chosen so that it is completely depleted in operation.

This causes a potential barrier between, for example, an higher doped n⁺-doped source and a lower doped n-doped drift regions resulting in a normally-off device with the entire drain voltage supported by the n-doped drift regions. Thus, the power semiconductor device can block high forward voltages at zero gate bias with low leakage currents. When a positive gate bias is applied, an accumulation channel of electrons at an insulator-SiC interface is created and, hence, a low resistance path for the electron current flow from the source to the drain is achieved. This structure offers the possibility of moving the accumulation channel away from the insulator interface, thereby removing the influence of bad interface quality on the accumulation channel mobility.

For example, a so-called 'gate-first' integration is proposed. That is, the gate insulator, the gate itself, which may be of highly doped Si or of at least one metal, and a gate passivation is deposited before the selective growth step using standard layer deposition and thermal oxidation techniques in order to assure best possible layer qualities of, for example, the gate insulator.

Accordingly, the power semiconductor device described herein may be based on selectively grown SiC pillars in a semiconductor layer stack comprising 3C SiC and 4H SiC on a substrate of, for example, doped or undoped Si, or a wide bandgap material like SiC, sapphire or GaN, wherein the power semiconductor device may be of the AccuFET design, and may be produced by means of a self-aligned gate first process.

According to at least one embodiment, the gate electrode layer is a continuous layer. Thus, there may be exactly one gate electrode layer having a plurality of holes, seen in top view, in which the pillars are located. Hence, the gate electrode may be limited to a space laterally adjacent to the pillars and may not exceed the pillars along a growth direction and/or a direction of main extent of the pillars; 'laterally' refers to a direction in parallel with the common plane in which the gate electrode layer is located. This does not exclude that the gate electrode layer is electrically contacted with at least one gate electrode line which is not located between the pillars and which may have a greater extent perpendicular to the common plane than the pillars.

The pillars are in contact with the first main electrode. Hence, the first main electrode may directly be produced on the pillars.

According to at least one embodiment, the common plane is perpendicular to the growth direction and/or the direction of main extent of the pillars. Accordingly, the common plane can be in parallel with the first main electrode and the second electrode. The common plane can be in a center of the gate electrode layer, seen along a height and/or the direction of main extent of the pillars.

According to at least one embodiment, the channel regions of the pillars are each in direct contact with the respective top region. Otherwise, there may be at least one intermediate region between the assigned top regions and channel regions.

According to at least one embodiment, the pillars comprise SiC or consist of SiC. Otherwise, the pillars may comprise or may consist of another high-bandgap compound semiconductor material like Ga₂O₃ or GaN.

According to at least one embodiment, seen in cross-section through the common plane and seen in parallel with the common plane, a width of the pillars is at least 0.05 µm or at least 0.1 µm or at least 0.2 µm. Alternatively or additionally, said width is at most 2 µm or at most 1.0 µm or at most 0.6 µm.

According to at least one embodiment, seen in cross-section through the common plane and seen perpendicular to the common plane, a height of the pillars is at least twice or at least 5 times the width of the pillars. Alternatively or additionally, said height is at most 50 times or at most 20 times or at most ten times the width of the pillars.

According to at least one embodiment, seen in top view of the common plane, a density of the pillars is at least 2 x 10⁵ cm⁻² or at least 1 x 10⁶ cm⁻² or at least 1 x 10⁷ cm⁻². Alternatively or additionally, said density is at most 1 x 10⁸ cm⁻² or at most 4 x 10⁷ cm⁻² or at most 2 x 10⁷ cm⁻².

At side walls of the pillars there is a gate insulator wall. The gate insulator wall extends all around the pillars. For each pillar, there is one gate insulator wall of, for example, tubular or truncated conical shape. For example, the gate insulator wall is of thermal silicon dioxide.

According to at least one embodiment, at a side of the gate electrode facing the first main electrode there is a top gate insulator layer. Alternatively or additionally, at a side of the gate electrode facing the second main electrode there is a bottom gate insulator layer. The top gate insulator layer and the bottom gate insulator layer can be in direct contact with the first main electrode and the second main electrode, respectively. For example, top gate insulator layer and/or the bottom gate insulator layer are of silicon dioxide.

According to at least one embodiment, the top gate insulator layer terminates flush with the top regions of the pillars, for example, with a tolerance of at most 0.3 µm or of at most 0.1 µm. That is, a side of the top regions and a side of the top gate insulator layer facing away from the first main electrode may be in a same or approximately in a same plane in parallel with the common plane.

According to at least one embodiment, the pillars each comprise a bottom region on a side of the respective channel region facing the second main electrode. The bottom regions can be in direct contact with the assigned channel region. Alternatively or additionally, the bottom regions may be in direct contact with the second main electrode.

According to at least one embodiment, a third doping concentration of the bottom regions is the first doping concentration, for example, with a tolerance of at most a factor of five or of at most a factor of two or of at most a factor of 1.5. Hence, the top regions and the bottom regions may be of the same or approximately of the same conductivity.

According to at least one embodiment, the bottom gate insulator layer terminates flush with the bottom regions of the pillars, for example, with a tolerance of at most 0.3 µm or of at most 0.1 µm. That is, a side of the bottom regions and a side of the bottom gate insulator layer facing the first main electrode may be in a same or approximately in a same plane in parallel with the common plane.

According to at least one embodiment, the pillars have in each case the shape of a truncated cone, of a truncated pyramid, of a prism or of a cylinder. If the pillars are shaped like a truncated cone or a truncated pyramid, an opening angle of the truncated cones or truncated pyramid is, for example, at least 10° or at least 20° and/or at most 70° or at most 35° or at most 25°. Said opening angle is determined, for example, in a plane perpendicular to the common plane and though a center axis of the respective pillar. A truncated cone or a truncated pyramid is a cone or a pyramid from which the tip has been removed. It is not necessary that the tip has been removed by a cut perpendicular to an axis of the cone or pyramid, but also oblique cuts can be realized. Further, a basis of the respective cone or pyramid does not need to be a face perpendicular to the axis of the cone or pyramid, but can be arranged in an oblique manner, too.

The pillars are also in contact with the second main electrode. Hence, the pillars extend from the first main electrode to the second main electrode. Accordingly, the semiconductor layer stack can consist of the plurality of pillars.

According to at least one embodiment, the power semiconductor device is a device for high electric powers. For example, the power semiconductor device is configured for a maximum current through the channel region of at least 1 A or of at least 20 A. As an option, the maximum current is at most 500 A. Alternatively or additionally, the power semiconductor device is configured for a maximum voltage of at least 0.1 kV or of at least 0.2 kV or of at least 1.2 kV. As an option, the maximum voltage may be at most 6.5 kV or at most 1.5 kV or at most 0.5 kV.

A footprint of the tubes is, for example, square or circular or polygonal or elliptic.

According to at least one embodiment, the power semiconductor device is a field-effect transistor, FET for short, or is comprised in a FET. Otherwise, the power semiconductor device can be part of an insulated-gate bipolar transistor (IGBT), which may additionally comprise an additional semiconductor layer stack as a collector region.

The power semiconductor device is, for example, for a power module in a vehicle to convert direct current from a battery to alternating current for an electric motor, for example, in hybrid vehicles or plug-in electric vehicles. Moreover, the power semiconductor device can be a fuse, for example, in a vehicle like a car.

A method for producing a power semiconductor device is additionally provided. By means of the method, a power semiconductor device is produced as indicated in connection with at least one of the above-stated embodiments. Features of the power semiconductor device are therefore also disclosed for the method and vice versa.

The method for producing a power semiconductor device comprising the following steps, for example, in the stated order:
A) providing a semiconductor substrate,
B) providing a semiconductor mask on the semiconductor substrate for pillars of a semiconductor layer stack,
C) forming tubes of an insulator material at side walls of the semiconductor mask, and
D) growing the pillars comprising, for example, SiC, in or around the tubes, the tubes are still present in the finished power semiconductor device.

Instead of a semiconductor mask, an oxide mask or a nitride mask may also be used.

One challenge for power semiconductor devices described herein like low voltage class power SiC MOSFETs is the low inversion channel mobility and, thus, poor on-resistance. Especially for devices which could be used for electric and hybrid electric vehicles enhanced channel mobility is key to improve switching and conduction losses.

In the power semiconductor devices described herein, for example, the vertical SiC power MOSFET design using selectively grown SiC tubes is suggested. Whereas a standard n+-type 4H SiC substrate and epitaxial n--type 4H SiC can be used as drift layer, selectively grown n-type 3C SiC which exhibits high carrier mobility is supposed to be the channel and source region. Thus, this concept combines the advantages of two SiC polytypes, namely 3C SiC and 4H SiC, to enable power semiconductor devices like high performance SiC power MOSFETs, for example, for low voltage applications.

With this method, improved superjunction structures, SJ structures for short, can be produced. Whereas in conventional superjunction structures n-type and p-type doped semiconductor regions are in direct contact, in the method described here a superjunction structure can also be formed with a thin insulator layer, like an oxide, in between the alternatively doped semiconductors; 'thin' means, for example, a thickness of at least 1 nm and/or of at most 10 nm.

Since this insulator layer might be used as a growth mask material for selective epitaxy, a further advantage is a two-step selective epi-growth of an in-situ doped superjunction with a layer thickness of, for example, more than 10 µm. Moreover, when using patterned stripe, hexagonal or square or other growth masks, the density of defects arising from a lattice mismatch or the substrate itself can be significantly reduced due to defect trapping along an semiconductor/insulator interface, also referred to as aspect ratio trapping. Thus, crystal defects will not extend into the superjunction structure itself and high channel carrier mobility can be achieved.

According to at least one embodiment, method step B) comprises the following sub-steps:
B1) growing a continuous starting layer or an already structured starting layer,
B2) optionally, structuring the continuous starting layer so that the semiconductor mask is provided, the semiconductor mask is a positive of the pillars.

According to at least one embodiment, the semiconductor mask is completely removed after step C) and before step D). That is, the mask is not present when growing the pillars and consequently is not present in the finished device.

According to at least one embodiment, in step D) the pillars are selectively grown in the tubes and a space between adjacent tubes is free of any solid material. Accordingly, the pillars may be grown on all locations where no material of the tubes is located on the substrate. A growth of the pillars is thus limited to the tubes and along the tubes.

According to at least one embodiment, the method comprises: E) producing the gate electrode layer between the pillars. Step E) may be done after step D) or otherwise before step D).

According to at least one embodiment, in method step B) the semiconductor mask is provided as a negative of the pillars, wherein after step C) a space between adjacent tubes is filled with at least one filling material or with at least one further semiconductor material in a step C1). For example, between steps C1) and D) the semiconductor mask can be removed. In this case, the semiconductor mask can completely be removed after step C) and before step D).

According to at least one embodiment, the semiconductor substrate is a Si substrate. Otherwise the semiconductor substrate is of SiC, GaN or sapphire.

According to at least one embodiment, the semiconductor substrate is removed after step D). Thus, the semiconductor substrate is not present in the finished power semiconductor device. Otherwise, the semiconductor substrate can be part of the semiconductor layer stack and, thus, can be an integral part of the finished power semiconductor device.

A power semiconductor device and a method described herein are explained in greater detail below by way of exemplary embodiments with reference to the drawings. Elements which are the same in the individual figures are indicated with the same reference numerals. The relationships between the elements are not shown to scale, however, but rather individual elements may be shown exaggeratedly large to assist in understanding.

In the figures:
- Figure 1: is a schematic perspective view of an exemplary embodiment of a power semiconductor device described herein,
- Figure 2: is a schematic sectional view of the power semiconductor device of Figure 1,
- Figures 3 to 6: are schematic sectional views of exemplary embodiments of power semiconductor devices described herein which are not covered by the claims but which are useful for understanding the invention,
- Figures 7 to 13: are schematic sectional views of method steps of an exemplary embodiment of a method to produce power semiconductor devices described herein,
- Figures 14 to 16: are schematic sectional views of method steps of an exemplary embodiment of a method to produce power semiconductor devices described herein,
- Figures 17 to 19: are schematic sectional views of method steps of an exemplary embodiment of a method to produce power semiconductor devices described herein,
- Figure 20: is a schematic perspective view of an exemplary embodiment of a power semiconductor device described herein which is not covered by the claims but which is useful for understanding the invention,
- Figure 21: is a schematic top view of the power semiconductor device of Figure 20,
- Figure 22: is a schematic top view of another exemplary embodiment of the power semiconductor device of Figure 20,
- Figure 23: is a schematic perspective view of an exemplary embodiment of a power semiconductor device described herein which is not covered by the claims but which is useful for understanding the invention, and
- Figure 24: is a schematic top view of the power semiconductor device of Figure 23.

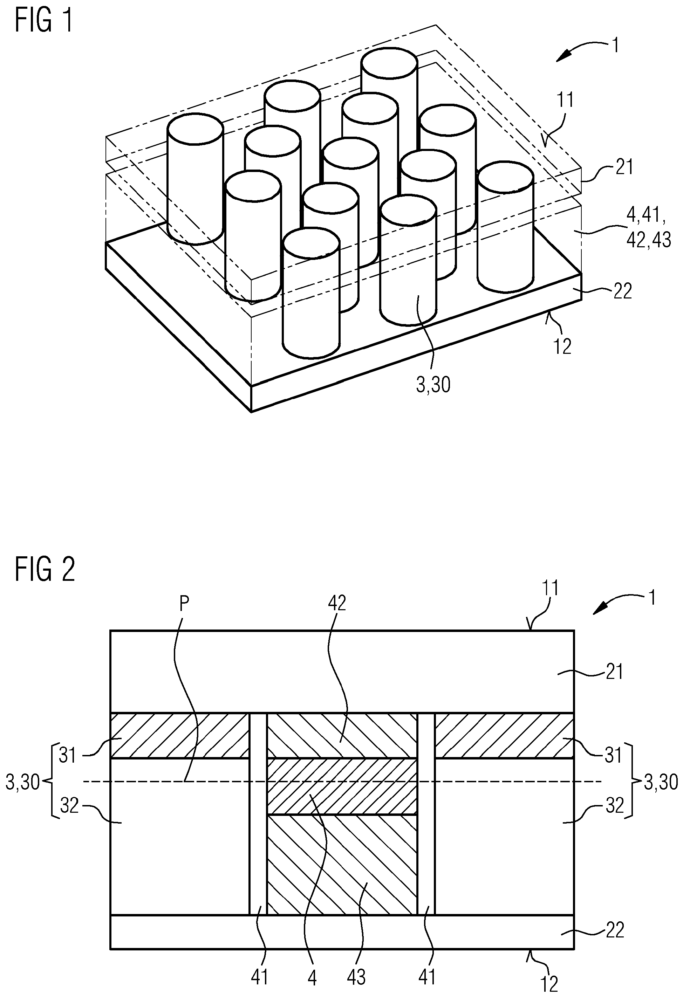

In Figures 1 and 2, an exemplary embodiment of a power semiconductor device 1 is illustrated. The power semiconductor device 1 comprise a first main electrode 21 at a first main side 11 and a second main electrode 22 at a second main side 12. The first and the second main electrodes 21, 22 are, for example, metallic electrodes.

Between the first and the second main electrodes 21, 22 there is a semiconductor layer stack 3 consisting of a plurality of pillars 30. Thus, the pillars 30 run from the first main electrode 21 to the second main electrodes 22. Moreover, between the first and the second main electrodes 21, 22 there is a gate electrode layer 4 embedded between a top gate insulator layer 42 and a bottom gate insulator layer 43. At side walls of the pillars 30, there are gate insulator walls 41. It is noted that in Figure 2 two pillars 30 are illustrated with a part of the gate electrode layer 4 in between. For example, the gate electrode layer 4 is of highly doped silicon.

The gate electrode layer 4 defines a common plane P which is perpendicular to a direction of main extent of the pillars 30 and, thus, perpendicular to a growth direction of the pillars 30. The common plane P may run in parallel with the first and the second main electrodes 21, 22 and may be located in a center of the gate electrode layer 4. By means of the gate insulators 41, 42, 43, gate electrode layer 4 is electrically insulated from the first and the second main electrodes 21, 22 as well as from the semiconductor layer stack 3. There can be a gate electrode line, not shown, that provides external electric contact to the gate electrode layer 4.

The pillars 30 and, thus, the semiconductor layer stack 3 is of only one conductivity type. For example, the semiconductor layer stack 3 consists of n-type doped 3C SiC. Hence, the power semiconductor device 1 may be a so-called AccuFET device.

The pillars 30 each comprise a top region 31 at the first main electrode 21 and a channel region 32 between the top region 31 and the second main electrode 22. The top region 31 is n⁺-doped with a first doping concentration of, for example, 3 x 10¹⁹ cm⁻³. Compared with that, the channel region 32 is weakly doped with a lower second doping concentration of, for example, 5 x 10¹⁶ cm⁻³.

In a direction perpendicular to the common plane P, the top region 31 can terminate flush with the top gate insulator layer 42. For example, a thickness of the top region 31 and/or the top gate insulator layer 42 and/or the bottom gate insulator layer 43 is at least 0.1 µm and/or at most 1 µm, for example, 0.3 µm. A thickness of the channel region 32 exceeds the thickness of the top region 31 in the direction perpendicular to the common plane P by at least a facto of two and/or by at most a factor of 20, for example.

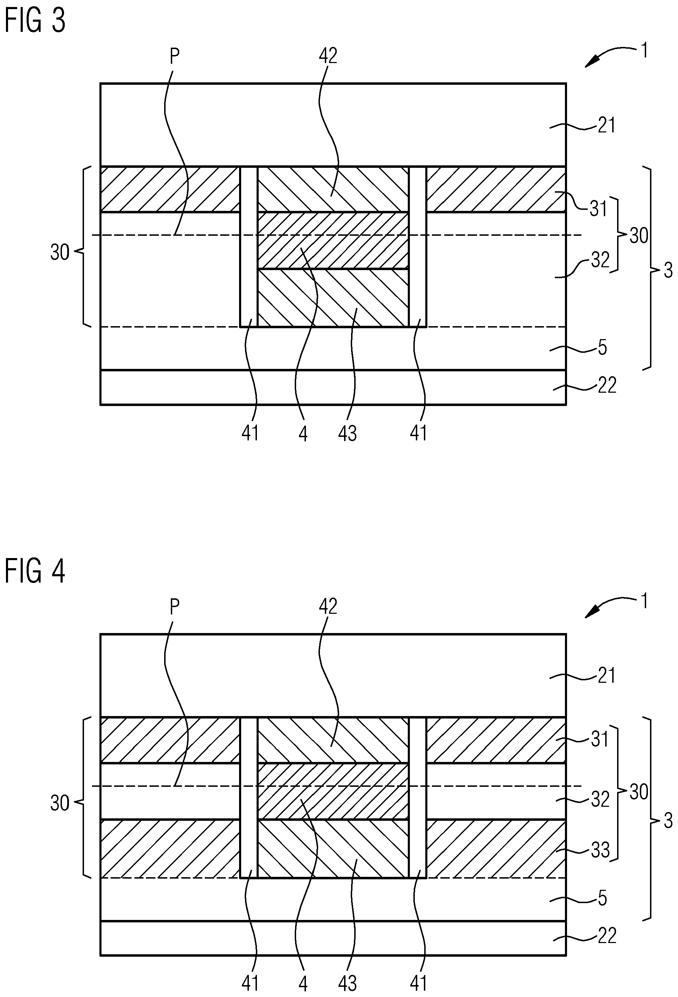

In the exemplary embodiment of Figure 3, the semiconductor layer stack 3 further comprises a base layer 5. To simplify the drawing, there is only one base layer 5 in Figure 3. However, there can also be a plurality of such layers. The at least one base layer 5 is a continuous layer at which all the pillars 30 start. The base layer 5 can be in direct contact with the second main electrode 22. The base layer 5 is of the same conductivity type as the pillars 30 so that the whole semiconductor layer stack 3 is either n-doped or p-doped.

For example, the base layer 5 comprises a SiC substrate of 4H SiC, and can include an epitaxially grown drift region and/or at least one buffer layer, not shown. A thickness of the base layer 5 is, for example, at least 0.01 µm and/or at most 10 µm in case of a solely epitaxially grown layer, or at least 5 µm and/or at most 0.5 mm in case of a growth substrate. The common plane P may be in parallel with a side of the base layer 5 facing the first main electrode 21.

Otherwise, the same as to Figures 1 and 3 may also apply for Figure 3.

According to Figure 4, the pillars 30 each comprise a bottom region 33 at a side of the channel region 32 remote from the top region 31. The bottom region 33 is, for example, of n-type doped 3C SiC. For example, a third doping concentration of the bottom region 33 is the same as the first doping concentration of the top region 31. The bottom region 33 may be in direct contact with the base layer 5 or, if there is no such base layer like in Figures 1 and 2, in direct contact with the second main electrode 22.

In the direction perpendicular to the common plane P, the bottom region 33 may terminate flush with the bottom gate insulator layer 43. For example, a thickness of the bottom region 33 is at least 0.1 µm and/or at most 1 µm, for example, 0.3 µm. The thickness of the channel region 32 exceeds the thickness of the bottom region 31 in the direction perpendicular to the common plane P by at least a facto of two and/or by at most a factor of 20, for example.

Otherwise, the same as to Figures 1 to 3 may also apply for Figure 4.

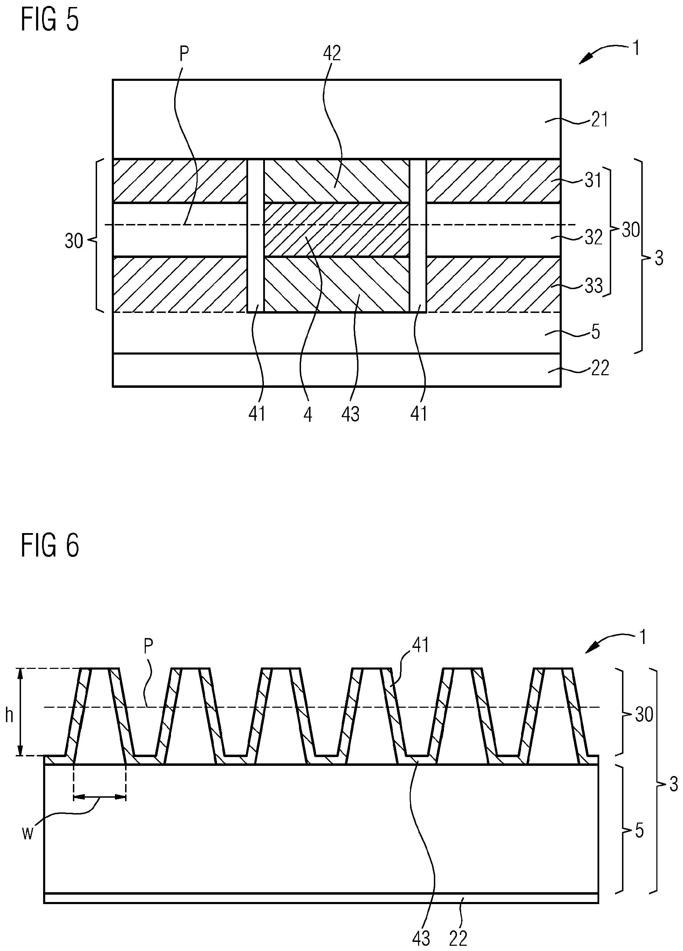

According to Figure 5, the pillars 30 become narrower along a direction away from the second main electrode 22 and, thus, towards the first main electrode 21. The pillars 30 may have the shape of truncated cones. An opening angle of the truncated cone is, for example, 30°. Such cone-shaped pillars 30 can also be used in the exemplary embodiments of Figures 1 and 2 as well as of Figure 4.

Otherwise, the same as to Figures 1 to 4 may also apply for Figure 5.

Also in the exemplary embodiment of Figure 6 the pillars 30 converge in the direction towards the first main electrode 21. Contrary to Figure 5, the gate insulator walls 41 and the bottom gate insulator layer 43 are made of one piece. Moreover, the cone-shaped pillars 30 may have an opening angle of just 15° or less, for example.

A width w of the pillars 30, measured at the side of the pillars 30 facing the second main electrode 22, is, for example, at least 0.3 µm and/or at most 1 µm. A height h of the pillars 30 in the direction perpendicular to the common plane P is, for example, at least 2 µm and/or at most 10 µm. A pitch of the pillars 30, that is, a distance between adjacent center lines of the pillars 30 measured in parallel with the common plane P is, for example, at least 2 µm and/or at most 10 µm. A density of the pillars 30 on the second main electrode 22 is, for example, at least 2 x 10⁶ cm⁻² and/or at most 5 x 10⁷ cm⁻². These values may individually or collectively apply to all other exemplary embodiments, too.

Otherwise, the same as to Figures 1 to 5 may also apply for Figure 6.

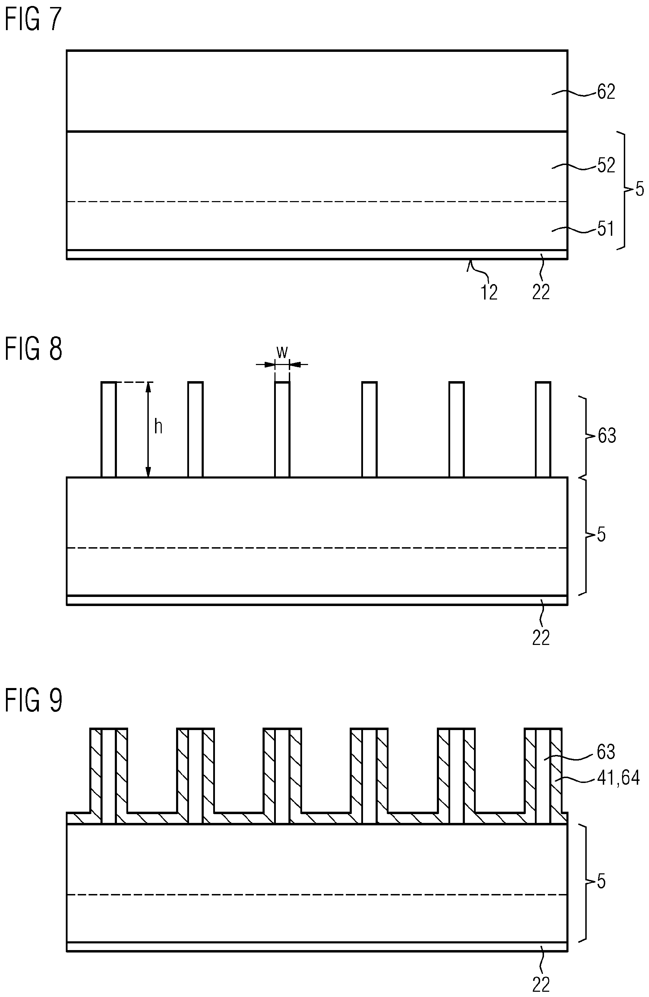

In Figures 7 to 13, a method for producing the power semiconductor device is illustrated. According to Figure 7, the base layer 5 is provided. The base layer 5 can include a comparably thick semiconductor substrate 51 of, for example, 4H SiC of n⁺-doping type.

As an option, on top of the semiconductor substrate 51 there is a drift region 52 of, for example, 4H SiC of n⁻-doping type. The drift region 52 has, for example, a doping concentration of at least 1 x 10¹⁵ cm⁻³ and/or of at most 3 x 10¹⁶ cm⁻³, for example, 4 x 10¹⁵ cm⁻³.

A thickness of the semiconductor substrate 51 is, for example, at least 0.1 mm and/or at most 1 mm. A thickness of the optional drift region 52 may be at least 0.1 µm and/or at most 1 µm. The same can apply to all other exemplary embodiments.

Moreover, on the base layer 5 there is a starting layer 62 for a later semiconductor mask 63. For example, the starting layer 62 is of amorphous silicon.

In the method step of Figure 8, the starting layer 62 is structured to become the semiconductor mask 63 by means of etching. The semiconductor mask 63 is a positive of the later pillars 30 and individual columns of the semiconductor mask 63 may have a height h of 2 µm to 5 µm and a width w of 0.3 µm to 1 µm.

According to Figure 9, the columns of the semiconductor mask 63 are oxidized to create tubes 64 for the later gate insulator walls 41. The tubes 64 are, thus, for example, of thermal SiO₂. Moreover, tops of these columns of the semiconductor mask 63 are etched down using, for example, reactive ion etching to expose tops of the columns. A wall thickness of the tubes 64 is, for example, between 5 nm and 0.2 µm inclusive.

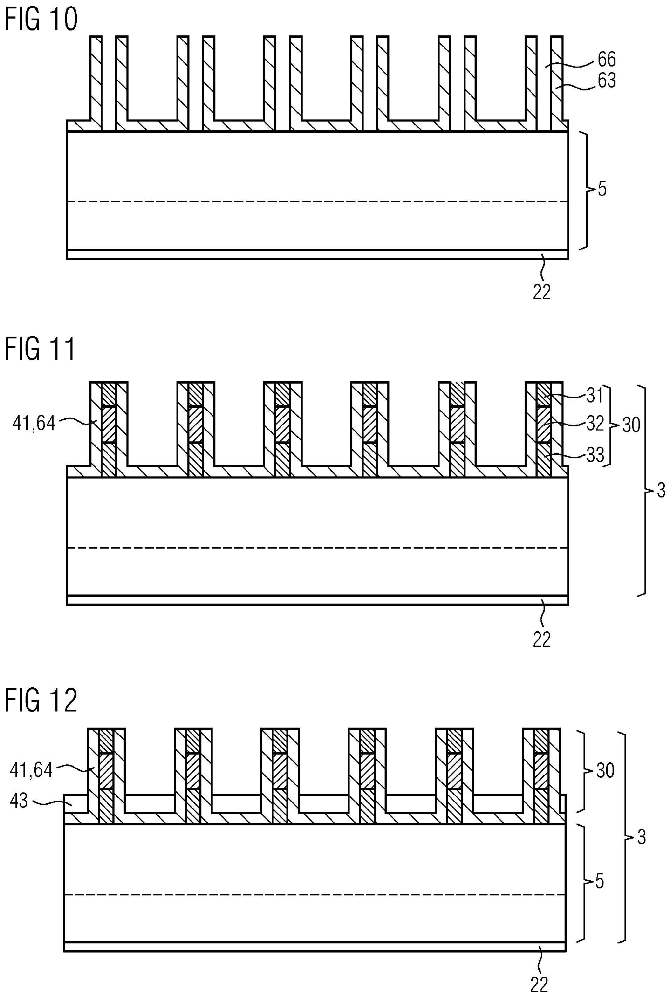

Next, see Figure 10, the amorphous Si columns of the semiconductor mask 63 are completely etched away using, for example, tetramethylammonium hydroxide, TMAH for short, and the hollow tubes 64 of SiO₂ remain on a surface of the base layer 5. The tubes 64 thus surround cavities 66.

In the step according to Figure 11 the pillars 30 are grown in the tubes 64 starting on the base layer 5. Because the semiconductor material for the pillars 30 does not grow on the material used for the tubes 64, a shape of the pillars 30 is well-defined and an interface between the tubes 64 and the pillars 30 is of high quality. That is, growth is prevented on all areas and surfaces on the base layer 5 that are covered with SiO₂. Only inside the hollow tubes 64 the 3C SiC pillars 30 are grown, which can be in-situ doped as required.

Then, see Figure 12, optionally a planarization is performed using, for example, spin-on-glass, SOG for short. Hence, the bottom gate insulator layer 43 can be created.

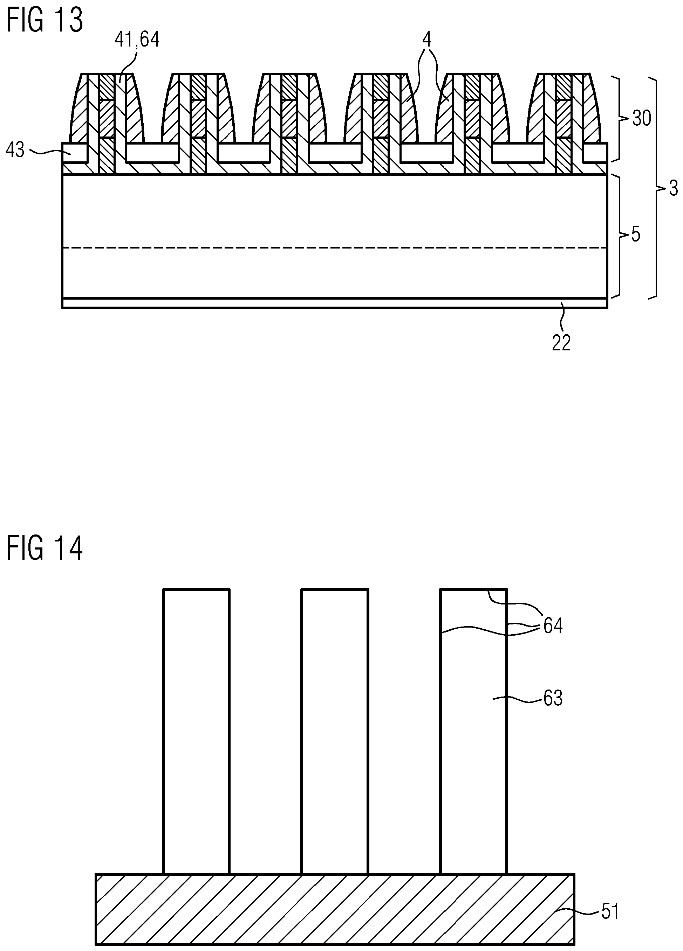

Subsequently, see Figure 13, a self-aligned gate process enables a gate-all-around device design so that the gate electrode layer 4 is produced. As also possible in all other exemplary embodiments, the gate electrode layer 4 may be divided into two parts between adjacent pillars 30 contrary to what is illustrated in Figures 1 to 5.

The final steps of producing the top gate insulator layer and the first main electrode are not shown in the method of Figures 7 to 13.

Otherwise, the same as to Figures 1 to 6 may also apply for Figures 7 to 13.

In Figures 14 to 16, another method for producing power semiconductor devices 1, 1* is illustrated. The produced power semiconductor devices 1, 1* can be AccuFETs as illustrated in Figures 1 to 6, for example, but can also be IGBTs or diodes or vertical FETs. For example, the structure produced with the method of Figures 14 to 16 is a superjunction structure accommodated in the base layer 5 of the power semiconductor devices 1 of, for example, Figures 3 to 6.

According to Figure 14, the semiconductor substrate 51 is provided which may be of n⁺-doped SiC. Moreover, a semiconductor mask 63 of, for example, silicon is applied to the semiconductor substrate 51.

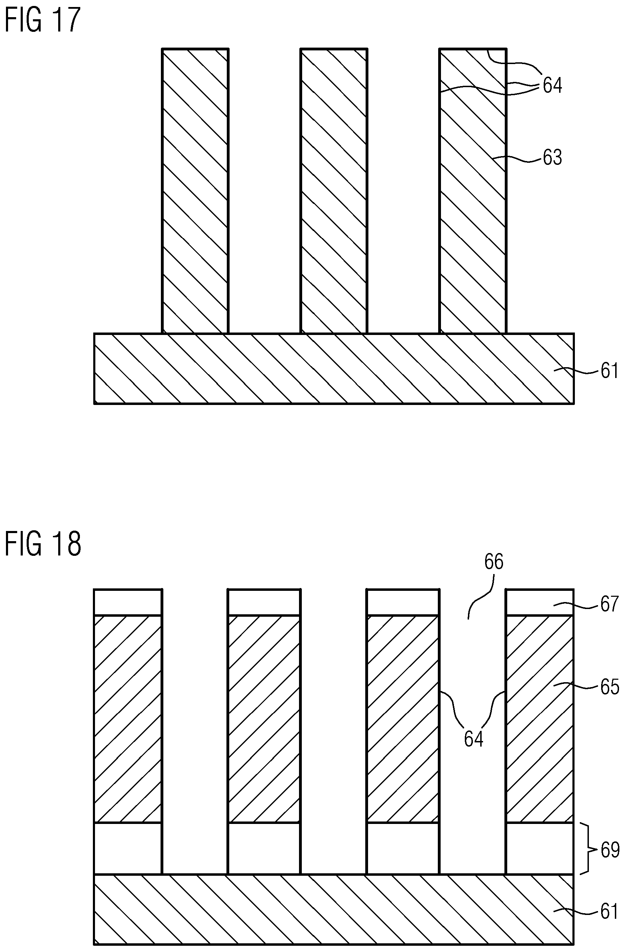

In a first variant, the semiconductor mask 63 can be a positive of the pillars produced later and can consequently be composed of a plurality of columns. Otherwise, in a second variant, the semiconductor mask 63 can be a negative of the later pillars and, thus, can be a continuous layer comprising holes for the later pillars. In Figures 14 to 16 as well as in Figures 17 to 19, the first variant is illustrated, but of course the same applies analogously to the second variant although not explicitly fully described.

Hence, following the first variant, see also Figure 14, the columns of the semiconductor mask 63 are oxidized so that the tubes 64 result. If, for example, a superjunction is produced then the wall thickness of the tubes 64 is, for example, between 1 nm and 10 nm inclusive. Otherwise, if a gate insulator wall 41 is produced then the wall thickness can be greater and can be, for example, between 5 nm and 0.2 µm inclusive.

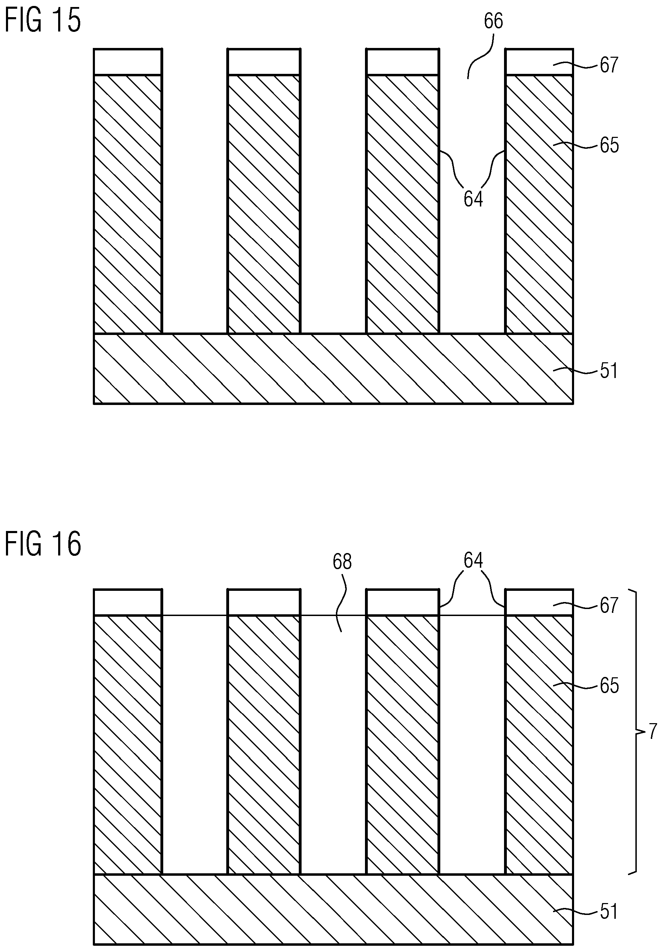

Subsequently, see Figure 15, a filling material 65 is grown between the still present columns of the semiconductor mask 63. The filling material 65 is, for example, n⁺-doped SiC or n⁻-doped SiC. Thus, according to the first variant the filling material 65 is a continuous layer enclosing the columns of the semiconductor mask 63. Otherwise, in the second variant, the filling material 65 would be shaped as a plurality of columns. However, in both variants there are tubes 64, and the only difference is that the filling material 65 is located either outside or inside the tubes 64.

As an option, a cap layer 67 may be grown on top of the filling material 65. A thickness of the cap layer 67 is, for example, at most 10% of a thickness of the filling material 65. The cap layer 67 is, for example, n⁻-doped SiC.

Then, see also Figure 15, in the first variant the columns of the semiconductor mask 63 are removed so that the cylindrical cavities 66 result. However, the tubes 64 remain intact. In the second variant, not shown, accordingly there are no cylindrical cavities but an empty space around the then pillar shaped filling material 65.

As an option, the cap layer 67 may also be provided with an oxide layer which can be like the tubes 64.

Afterwards, see Figure 16, according to the first variant the cavities 66 are filled with a further semiconductor material 68 that can constitute, for example, the pillars 30 as explained in Figures 1 to 6. For example, the further semiconductor material 68 is p⁺-doped SiC in case of a superjunction structure 7. Otherwise, for a AccuFET, for example, the further semiconductor material 68 is n⁻-doped SiC for the channel regions and n⁺-doped SiC for the top regions. According to the second variant, the further semiconductor material 68 would be a continuous layer formed around the pillar-shaped filling material 65, but in each case there is the insulator material of the tubes 64 between the filling material 65 and the further semiconductor material 68.

In subsequent optional steps, not shown, it is possible to provide, if required, a planarization layer and to perform the method steps of Figures 7 to 13 atop the planarization layer to further create an AccuFET structure atop the superjunction structure 7 that could be formed by the method steps of Figures 14 to 16.

The same concept illustrated in Figures 14 to 16 works using an oxide or nitride mask, not shown, instead of the semiconductor mask 63. Then, in this variant the filling material 65 is applied, followed by oxidation or oxide deposition, not shown. Before the growth step of the further semiconductor material as illustrated in Figure 16, not shown, in this variant an anisotropic oxide removal at a bottom of the cavities is performed so that the further semiconductor material 68 can then be applied on the substrate 51.

As an alternative to the semiconductor filling material 65, it is also possible that the gate electrode layer as well as the top and bottom gate insulator layers as illustrated in Figures 1 to 6 can be applied instead.

The method of Figures 17 to 19 is essentially the same as in Figures 14 to 16, but instead of the SiC semiconductor substrate 51 that can be present in the finished power semiconductor device 1, 1*, a temporal Si semiconductor substrate 61 is used, see Figure 17.

Hence, near the Si semiconductor substrate 61 a defective buffer region 69 may result, see Figure 18.

This defective buffer region 69 may extend to the further semiconductor material 68 grown in the cavities 66. As an option, the defective buffer region 69 can be removed together with the semiconductor substrate 61, not shown.

Otherwise, the same as to Figures 14 to 16 may also apply for Figures 17 to 19. For example, both the first variant and the second variant as explained in connection with Figures 14 to 16 can also be applied in the method of Figures 17 to 19.

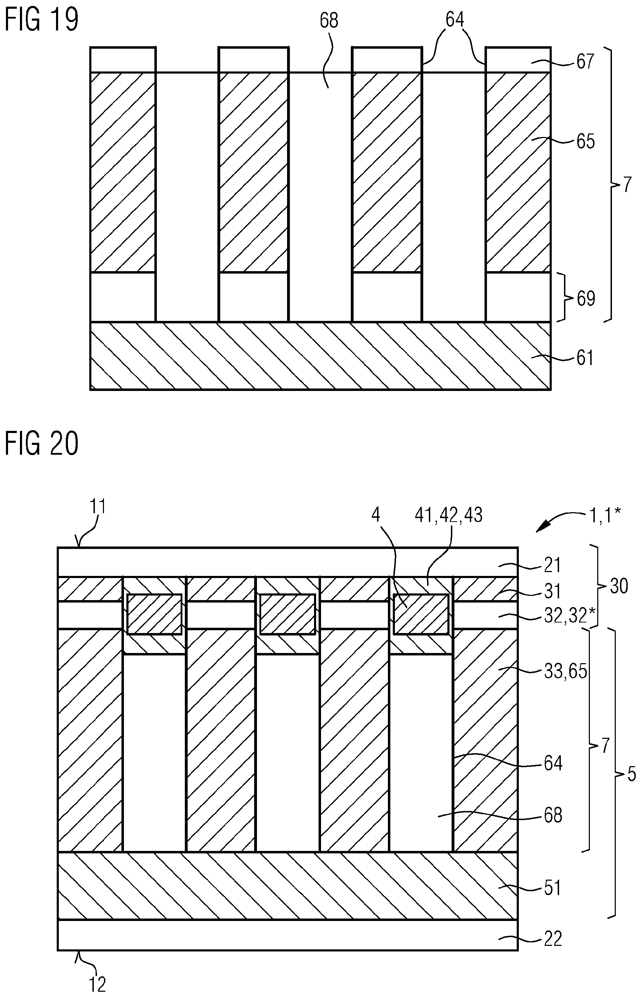

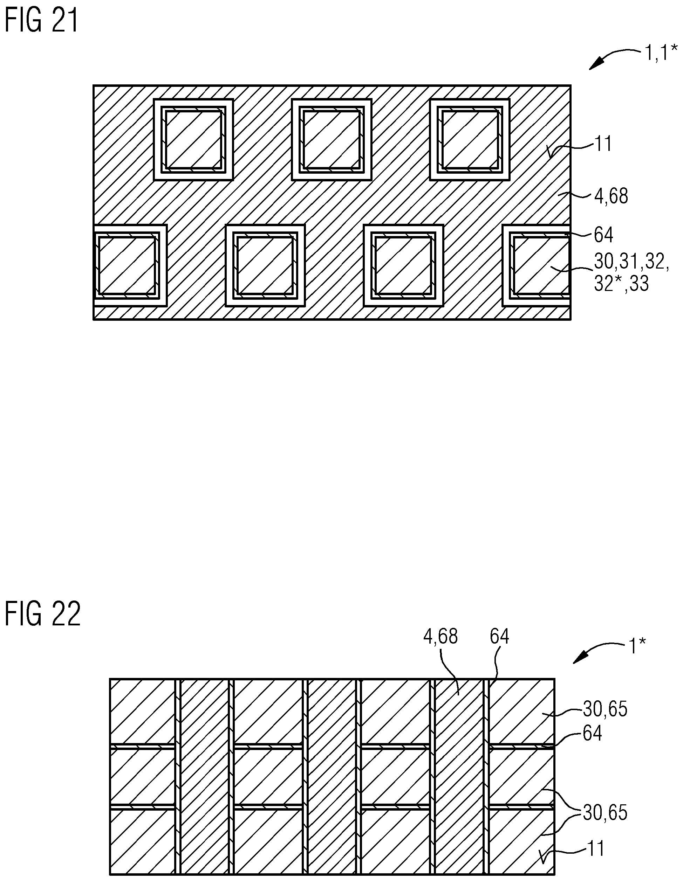

In Figures 20 and 21, an exemplary embodiment of the power semiconductor device 1 that is an AccuFET as well as an exemplary embodiment of the power semiconductor device 1* that is a superjunction FET are illustrated. These power semiconductor devices 1, 1* may be produced using, for example, the method of Figures 14 to 16 or of Figures 17 to 19.

In the case of the power semiconductor device 1 that is an AccuFET, the base layer 5 includes the superjunction structure 7 manufactured, for example, with the method of Figures 14 to 16. Accordingly, the pillars 30 include the n-doped top regions 31, the n-doped channel regions 32 and as an option the n-doped bottom regions 33. Between the gate electrode layer 4 and the second main electrode layer 22, there is the further semiconductor material 68 which may be p-doped, and which is separated from the n-doped regions by means of the tubes 64. The semiconductor substrate 51 is also n-doped.

In the case of the power semiconductor device 1* that is a superjunction MOSFET or superjunction MISFET, then there are the n-doped top regions 31, the p-doped channel regions 32* and the n-doped bottom regions 33 in the pillars 30 and as an option the n-doped semiconductor substrate 51 in the base layer 5.

As can be seen in Figure 21, the pillars 30 can be arranged in a hexagonal pattern and can have a square footprint. Otherwise, square or rectangular patterns can also be used. Moreover, circular or elliptic or polygonal footprints are also possible for the pillars 30. The same applies to all other exemplary embodiments.

Otherwise, the same as to Figures 1 to 19 may also apply for Figures 20 and 21.

In Figure 22 another exemplary embodiment of the power semiconductor device 1* is illustrated as a top view, the cross-sectional view is the same as in Figure 20. In this embodiment, the gate electrode layer 4 and, thus, the further p-doped semiconductor material 68 are structured as stripes that run, for example, in parallel with one another.

The filling material 65 is composed of a plurality of the pillars 30 arranged next to one another along the stripes of the gate electrode layer 4. Between adjacent pillars 30, there are in each case walls of the tubes 64 and, thus, walls of the insulator material the tubes 64 are made of. For example, a footprint of the pillars 30 is 1 µm x 1 µm and a thickness of the walls of the pillars 30 is 10 nm.

Otherwise, the same as to Figures 20 and 21 may also apply for Figure 22.

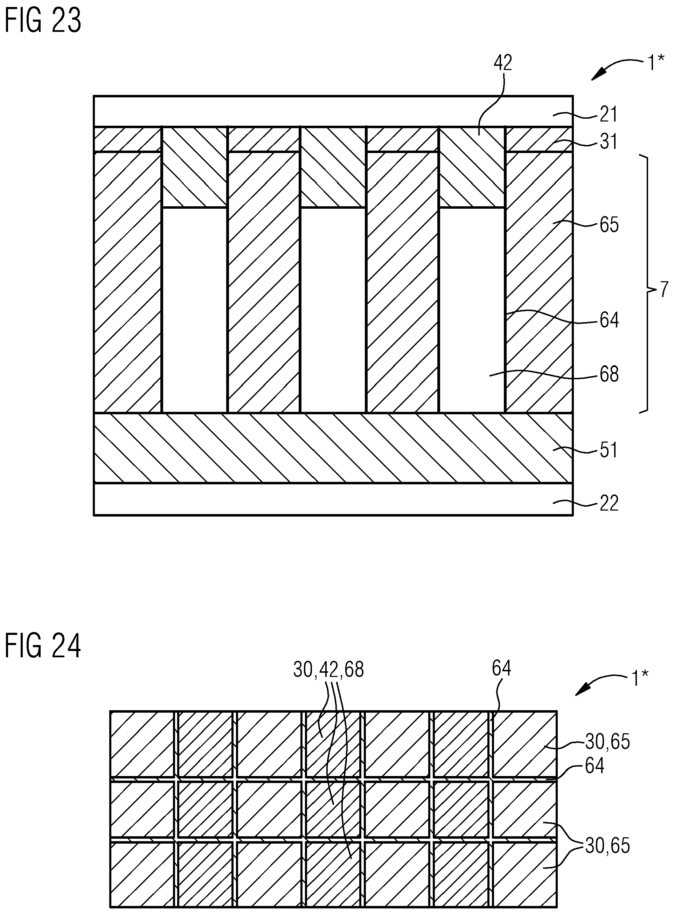

Another exemplary embodiment of the power semiconductor device 1* is illustrated in Figures 23 and 24. The power semiconductor device 1* is a superjunction Schottky diode comprising in the superjunction structure 7 the top regions 31 that may be n-doped, the filling material 65 that may also be n-doped and the further semiconductor material 68 that may be p-doped. As an option, there can be the common semiconductor substrate 51. An electrical insulator material 42 is arranged atop the further semiconductor material 68 and extends nearer towards the second main electrode 22 than the top regions 31.

Seen in top view, the further semiconductor material 68 as well as the filling material 65 can be arranged in stripes. In each case, the stripes are composed of a plurality of the respective columns 30. Between adjacent columns, there are the walls of the tubes 64. Such an arrangement concerning the further semiconductor material 68 may also be present in Figures 21 or 22.

Otherwise, the same as to Figures 1 to 22 may also apply for Figures 23 and 24.

Hence, the design of Figures 20 to 24 is possible, for example, for diodes and MOSFETs. It can be applied to pillar and stripe layouts with and without oxide bridges along the stripes for further defect capturing. The dimensions can be relatively small, such that additionally to a superjunction effect also volume inversion can occur to further improve conduction of current. An advantage of this concept is, for example, that gate refilling can be fully self-aligned in the pillars and does not require advanced lithography tools to obtain a low pitch of, for example, less than 1 µm.

With the superjunction structure 7, superior current blocking with smaller leakage can be achieved. The reason for smaller leakage is the smaller electric field at the metal/semiconductor interface. For a MOSFET, for example, this effect implies that an electric field at a gate insulator during blocking will be smaller than compared to conventional trench designs, yielding to better reliability and potentially thinner gate insulators to further improve performance of the power semiconductor devices 1, 1*.

Thus, to have superjunction structures allows the usage of alternative substrate material other than SiC like Si and of low temperature epitaxy reactors, because standard Si CVD can be used, since defective growth, stress and relaxation defects will be confined in a thin defective buffer region and do not extend towards a bulk region of the superjunction structure itself. Hence, smooth and crystalline layers can be grown at growth temperatures of lower than 1250 °C suitable for selective epitaxy. Hence, high performance wide bandgap superjunction devices can be obtained with superior conduction performance at relatively low cost.

### List of Reference Signs

- 1, 1*: power semiconductor device
- 11: first main side
- 12: second main side
- 21: first main electrode
- 22: second main electrode
- 3: semiconductor layer stack
- 30: pillar
- 31: top region
- 32: channel region, same conductivity type as top region
- 32*: channel region, other conductivity type than top region
- 33: bottom region
- 4: gate electrode layer
- 41: gate insulator wall
- 42: top gate insulator layer
- 43: bottom gate insulator layer
- 5: base layer of the semiconductor layer stack
- 51: semiconductor substrate, permanently present
- 52: drift region
- 61: semiconductor substrate, temporary present
- 62: starting layer for the semiconductor mask
- 63: semiconductor mask
- 64: tube of insulator material
- 65: filling material
- 66: cavity
- 67: cap layer
- 68: further semiconductor material
- 69: defective buffer region
- 7: superjunction structure
- h: height of the pillars
- P: common plane
- w: width of the pillars

## Claims

1. A power semiconductor device (1) comprising:
- a first main electrode (21),
- a second main electrode (22),
- a semiconductor layer stack (3) between and in contact with the first main electrode (21) and the second main electrode (22),
- a gate electrode layer (4) between the first main electrode (21) and the second main electrode (22), and
- tubes (64) of an insulator material forming gate insulator walls (41),
wherein
- the semiconductor layer stack (3) comprises a plurality of pillars (30) in contact with the first main electrode (21) and with the second main electrode (22) so that the pillars (30) extend from the first main electrode (21) to the second main electrode (22),
- the pillars (30) run through the gate electrode layer (4),
- the pillars (30) are in the tubes (64) and fill the tubes (64),
- the whole semiconductor layer stack (3) is of the same conductivity type at least in places from the first main electrode (21) to the second main electrode (22),
- each one of the pillars (30) comprises a top region (31) at the first main electrode (21) with a first doping concentration,
- at sides of the top regions (31) facing away from the first main electrode (21), and in a common plane (P) with the gate electrode layer (4), each of the pillars (30) comprises a channel region (32) with a second doping concentration, and
- the first doping concentration exceeds the second doping concentration by at least a factor of 10.

2. The power semiconductor device (1) according to claim 1, wherein the pillars (30) comprise SiC and extend perpendicular to the common plane (P).

3. The power semiconductor device (1) according to any one of the preceding claims,
wherein at least one of
- seen in cross-section through the common plane (P) and in parallel with the common plane (P), a width (w) of the pillars (30) is at least 0.05 µm and at most 1 µm,
- seen in cross-section through the common plane (P) and perpendicular to the common plane (P), a height (h) of the pillars (30) is at least twice the width (w) and at most 20 times the width (w), and
- seen in top view of the common plane (P), a density of the pillars (30) is between 1 x 10⁶ cm⁻² and 4 x 10⁷ cm⁻² inclusive.

4. The power semiconductor device (1) according to any one of the preceding claims,
wherein at side walls of the pillars (30) there is the gate insulator wall (41) all around the pillars (30), and
wherein at a side of the gate electrode (4) facing the first main electrode (21) there is a top gate insulator layer (42) and at a side of the gate electrode (4) facing the second main electrode (22) there is a bottom gate insulator layer (43), and
wherein the gate insulator walls (41) are of a thermal oxide.

5. The power semiconductor device (1) according to claim 4, wherein the top gate insulator layer (42) terminates flush with the top regions (31) of the pillars (30).

6. The power semiconductor device (1) according to any one of the preceding claims,
wherein the pillars (30) each comprise a bottom region (33) on a side of the respective channel region (32) facing the second main electrode (22).

7. The power semiconductor device (1) according to claim 6 and according to claim 4 or 5,
wherein the bottom gate insulator layer (43) terminates flush with the bottom regions (33) of the pillars (30).

8. The power semiconductor device (1) according to any one of the preceding claims,
wherein the pillars (30) have in each case the shape of a truncated cone, and
wherein an opening angle of the truncated cones is between 10° and 35° inclusive.

9. A method for producing a power semiconductor device (1, 1*) comprising:
A) providing a semiconductor substrate (51, 61),
B) providing a semiconductor mask (63) on the semiconductor substrate (51, 61) for pillars (30) of a semiconductor layer stack (3),
C) forming tubes (64) of an insulator material at side walls of the semiconductor mask (63), and
D) growing the pillars (30) comprising SiC in the tubes (64), wherein
- the tubes (64) are maintained in the finished power semiconductor device (1),
- the method further comprises providing a first main electrode (21) and a second main electrode (22), the semiconductor layer stack (3) is between and in contact with the first main electrode (21) and the second main electrode (22),
- the method further comprises providing a gate electrode layer (4) between the first main electrode (21) and the second main electrode (22),
- the semiconductor layer stack (3) comprises a plurality of the pillars (30) in contact with the first main electrode (21) and the pillars (30) run through the gate electrode layer (4),
- the whole semiconductor layer stack (3) is of the same conductivity type at least in places from the first main electrode (21) to the second main electrode (22),
- each one of the pillars (30) comprises a top region (31) at the first main electrode (21) with a first doping concentration,
- at sides of the top regions (31) facing away from the first main electrode (21), and in a common plane (P) with the gate electrode layer (4), each of the pillars (30) comprises a channel region (32) with a second doping concentration, and
- the first doping concentration exceeds the second doping concentration by at least a factor of 10,
and wherein either method step B) comprises the following sub-steps:
B1) growing a continuous starting layer (62),
B2) structuring the continuous starting layer (62) so that the semiconductor mask (63) is provided, the semiconductor mask (63) is a positive of the pillars,
wherein the semiconductor mask (63) is completely removed after step C) and before step D),
wherein in step D) the pillars (30) are selectively grown in the tubes (64) and a space between adjacent tubes (64) is free of any solid material in step D), and
wherein step D) is followed by step E):
E) producing the gate electrode layer (4) between the pillars (30),
or in method step B) the semiconductor mask (63) is provided as a negative of the pillars (30),
wherein after step C) a space between adjacent tubes (64) is filled with at least one filling material (65) or with at least one further semiconductor material (68) in a step C1), wherein between steps C1) and D) the semiconductor mask (63) is removed, and
wherein the semiconductor mask (63) is completely removed after step C) and before step D).

10. The method according to claim 9,
wherein the semiconductor substrate (51, 61) is a Si substrate,
wherein the semiconductor substrate (51, 61) is removed after step D).

## Patentansprüche

1. Leistungshalbleitervorrichtung (1), umfassend:
- eine erste Hauptelektrode (21),
- eine zweite Hauptelektrode (22),
- einen Halbleiterschichtstapel (3) zwischen der ersten Hauptelektrode (21) und der zweiten Hauptelektrode (22) und in Kontakt mit ihnen,
- eine Gate-Elektrodenschicht (4) zwischen der ersten Hauptelektrode (21) und der zweiten Hauptelektrode (22) und
- Röhren (64) aus einem Isolatormaterial, die Gate-Isolatorwände (41) bilden;
wobei
- der Halbleiterschichtstapel (3) mehrere Säulen (30) umfasst, die mit der ersten Hauptelektrode (21) und mit der zweiten Hauptelektrode (22) in Kontakt stehen, so dass sich die Säulen (30) von der ersten Hauptelektrode (21) zur zweiten Hauptelektrode (22) erstrecken;
- die Säulen (30) durch die Gate-Elektrodenschicht (4) verlaufen,
- sich die Säulen (30) in den Röhren (64) befinden und die Röhren (64) füllen,
- der gesamte Halbleiterschichtstapel (3) zumindest stellenweise von der ersten Hauptelektrode (21) bis zur zweiten Hauptelektrode (22) vom gleichen Leitfähigkeitstyp ist;
- jede der Säulen (30) ein oberes Gebiet (31) an der ersten Hauptelektrode (21) mit einer ersten Dotierungskonzentration umfasst;
- an Seiten der oberen Gebiete (31), die von der ersten Hauptelektrode (21) abgewandt sind und sich in einer gemeinsamen Ebene (P) mit der Gate-Elektrodenschicht (4) befinden, jede der Säulen (30) ein Kanalgebiet (32) mit einer zweiten Dotierungskonzentration umfasst, und
- die erste Dotierungskonzentration die zweite Dotierungskonzentration um mindestens den Faktor 10 übersteigt.

2. Leistungshalbleitervorrichtung (1) nach Anspruch 1, wobei die Säulen (30) SiC umfassen und sich senkrecht zur gemeinsamen Ebene (P) erstrecken.

3. Leistungshalbleitervorrichtung (1) nach einem der vorhergehenden Ansprüche,
wobei mindestens eines von Folgendem gilt:
- im Querschnitt durch die gemeinsame Ebene (P) und parallel zur gemeinsamen Ebene (P) betrachtet, beträgt eine Breite (W) der Säulen (30) mindestens 0,05 µm und höchstens 1 um;
- im Querschnitt durch die gemeinsame Ebene (P) und senkrecht zur gemeinsamen Ebene (P) betrachtet, beträgt eine Höhe (h) der Säulen (30) mindestens das Doppelte der Breite (W) und höchstens das 20-Fache der Breite (W), und
- in der Draufsicht auf die gemeinsame Ebene (P) betrachtet, liegt eine Dichte der Säulen (30) zwischen einschließlich 1 x 10⁶ cm⁻² und 4 x 10⁷ cm⁻².

4. Leistungshalbleitervorrichtung (1) nach einem der vorhergehenden Ansprüche,
wobei an den Seitenwänden der Säulen (30) die Gate-Isolatorwand (41) rund um die Säulen (30) herum vorhanden ist, und
wobei an einer der ersten Hauptelektrode (21) zugewandten Seite der Gate-Elektrode (4) eine obere Gate-Isolatorschicht (42) und an einer der zweiten Hauptelektrode (22) zugewandten Seite der Gate-Elektrode (4) eine untere Gate-Isolatorschicht (43) vorhanden ist, und
wobei die Gate-Isolatorwände (41) aus einem thermischen Oxid sind.

5. Leistungshalbleitervorrichtung (1) nach Anspruch 4, wobei die obere Gate-Isolatorschicht (42) bündig mit den oberen Gebieten (31) der Säulen (30) endet.

6. Leistungshalbleitervorrichtung (1) nach einem der vorhergehenden Ansprüche,
wobei die Säulen (30) jeweils ein unteres Gebiet (33) auf einer der zweiten Hauptelektrode (22) zugewandten Seite des jeweiligen Kanalgebiets (32) aufweisen.

7. Leistungshalbleitervorrichtung (1) nach Anspruch 6 und nach Anspruch 4 oder 5,
wobei die untere Gate-Isolatorschicht (43) bündig mit den unteren Gebieten (33) der Säulen (30) endet.

8. Leistungshalbleitervorrichtung (1) nach einem der vorhergehenden Ansprüche,
wobei die Säulen (30) jeweils die Form eines Kegelstumpfs haben, und
wobei ein Öffnungswinkel der Kegelstümpfe zwischen einschließlich 10° und 35° liegt.

9. Verfahren zum Herstellen einer Leistungshalbleitervorrichtung (1, 1*), umfassend:
A) Bereitstellen eines Halbleitersubstrats (51, 61),
B) Bereitstellen einer Halbleitermaske (63) auf dem Halbleitersubstrat (51, 61) für Säulen (30) eines Halbleiterschichtstapels (3),
C) Ausbilden von Röhren (64) aus einem Isolatormaterial an den Seitenwänden der Halbleitermaske (63) und
D) Aufwachsen der Säulen (30), die SiC umfassen, in den Röhren (64), wobei
- die Röhren (64) in der fertigen Leistungshalbleitervorrichtung (1) beibehalten werden,
- das Verfahren ferner das Bereitstellen einer ersten Hauptelektrode (21) und einer zweiten Hauptelektrode (22) umfasst, wobei sich der Halbleiterschichtstapel (3) zwischen der ersten Hauptelektrode (21) und der zweiten Hauptelektrode (22) befindet und in Kontakt mit ihnen steht,
- das Verfahren ferner das Bereitstellen einer Gate-Elektrodenschicht (4) zwischen der ersten Hauptelektrode (21) und der zweiten Hauptelektrode (22) umfasst,
- der Halbleiterschichtstapel (3) mehrere der Säulen (30) umfasst, die mit der ersten Hauptelektrode (21) in Kontakt stehen, und die Säulen (30) durch die Gate-Elektrodenschicht (4) verlaufen;
- der gesamte Halbleiterschichtstapel (3) zumindest stellenweise von der ersten Hauptelektrode (21) bis zur zweiten Hauptelektrode (22) vom gleichen Leitfähigkeitstyp ist;
- jede der Säulen (30) ein oberes Gebiet (31) an der ersten Hauptelektrode (21) mit einer ersten Dotierungskonzentration umfasst;
- an Seiten der oberen Gebiete (31), die von der ersten Hauptelektrode (21) abgewandt sind und sich in einer gemeinsamen Ebene (P) mit der Gate-Elektrodenschicht (4) befinden, jede der Säulen (30) ein Kanalgebiet (32) mit einer zweiten Dotierungskonzentration umfasst, und
- die erste Dotierungskonzentration die zweite Dotierungskonzentration um mindestens den Faktor 10 übersteigt;
und wobei entweder Verfahrensschritt B) die folgenden Teilschritte umfasst:
B1) Aufwachsen einer kontinuierlichen Startschicht (62),
B2) Strukturieren der kontinuierlichen Startschicht (62), so dass die Halbleitermaske (63) bereitgestellt wird, wobei die Halbleitermaske (63) ein Positiv der Säulen ist,
wobei die Halbleitermaske (63) nach Schritt C) und vor Schritt D) vollständig entfernt wird,
wobei in Schritt D) die Säulen (30) selektiv in den Röhren (64) aufgewachsen werden und ein Raum zwischen benachbarten Röhren (64) von jeglichem Feststoffmaterial in Schritt D) frei ist, und
wobei auf Schritt D) Schritt E) folgt:
E) Herstellen der Gate-Elektrodenschicht (4) zwischen den Säulen (30),
oder im Verfahrensschritt B) die Halbleitermaske (63) als ein Negativ der Säulen (30) bereitgestellt wird,
wobei nach Schritt C) ein Raum zwischen benachbarten Röhren (64) mit mindestens einem Füllmaterial (65) oder mit mindestens einem weiteren Halbleitermaterial (68) in einem Schritt C1) gefüllt wird,
wobei zwischen Schritten C1) und D) die Halbleitermaske (63) entfernt wird, und
wobei die Halbleitermaske (63) nach Schritt C) und vor Schritt D) vollständig entfernt wird.

10. Verfahren nach Anspruch 9,
wobei das Halbleitersubstrat (51, 61) ein Si-Substrat ist,
wobei das Halbleitersubstrat (51, 61) nach Schritt D) entfernt wird.

## Revendications

1. Dispositif à semi-conducteur de puissance (1), comprenant :
- une première électrode principale (21),
- une deuxième électrode principale (22),
- un empilement de couches semi-conductrices (3) entre et en contact avec la première électrode principale (21) et la deuxième électrode principale (22),
- une couche d'électrode de grille (4) entre la première électrode principale (21) et la deuxième électrode principale (22), et
- des tubes (64) en un matériau isolant formant des parois d'isolant de grille (41),
dans lequel
- l'empilement de couches semi-conductrices (3) comprend une pluralité de piliers (30) en contact avec la première électrode principale (21) et avec la deuxième électrode principale (22) de sorte que les piliers (30) s'étendent depuis la première électrode principale (21) jusqu'à la deuxième électrode principale (22),
- les piliers (30) traversent la couche d'électrode de grille (4),
- les piliers (30) sont dans les tubes (64) et remplissent les tubes (64),
- l'ensemble de l'empilement de couches semi-conductrices (3) est du même type de conductivité au moins par endroits depuis la première électrode principale (21) jusqu'à la deuxième électrode principale (22),
- chacun des piliers (30) comprend une région supérieure (31) au niveau de la première électrode principale (21) avec une première concentration de dopage,
- sur des côtés des régions supérieures (31) orientés à l'opposé de la première électrode principale (21), et dans un plan commun (P) avec la couche d'électrode de grille (4), chacun des piliers (30) comprend une région de canal (32) avec une deuxième concentration de dopage, et
- la première concentration de dopage dépasse la deuxième concentration de dopage d'au moins un facteur 10.

2. Dispositif à semi-conducteur de puissance (1) selon la revendication 1, dans lequel les piliers (30) comprennent du SiC et s'étendent perpendiculairement au plan commun (P).

3. Dispositif à semi-conducteur de puissance (1) selon l'une quelconque des revendications précédentes,
dans lequel au moins l'une des caractéristiques suivantes est remplie
- en vue en coupe transversale selon le plan commun (P) et parallèlement au plan commun (P), une largeur (w) des piliers (30) est d'au moins 0,05 µm et d'au plus 1 µm,
- en vue en coupe transversale selon le plan commun (P) et perpendiculairement au plan commun (P), une hauteur (h) des piliers (30) est au moins égale à deux fois la largeur (w) et au plus égale à 20 fois la largeur (w), et
- en vue de dessus du plan commun (P), une densité des piliers (30) est comprise entre 1 x 10⁶ cm⁻² et 4 x 10⁷ cm⁻² inclus.

4. Dispositif à semi-conducteur de puissance (1) selon l'une quelconque des revendications précédentes,
dans lequel au niveau de parois latérales des piliers (30) se trouve la paroi d'isolant de grille (41) tout autour des piliers (30), et
dans lequel au niveau d'un côté de l'électrode de grille (4) faisant face à la première électrode principale (21) se trouve une couche d'isolant de grille supérieure (42), et au niveau d'un côté de l'électrode de grille (4) faisant face à la deuxième électrode principale (22) se trouve une couche d'isolant de grille inférieure (43), et
dans lequel les parois d'isolant de grille (41) sont en oxyde thermique.

5. Dispositif à semi-conducteur de puissance (1) selon la revendication 4, dans lequel la couche d'isolant de grille supérieure (42) se termine à fleur des régions supérieures (31) des piliers (30).

6. Dispositif à semi-conducteur de puissance (1) selon l'une quelconque des revendications précédentes,
dans lequel les piliers (30) comprennent chacun une région inférieure (33) sur un côté de la région canal (32) respective faisant face à la deuxième électrode principale (22).

7. Dispositif à semi-conducteur de puissance (1) selon la revendication 6 et selon la revendication 4 ou 5,
dans lequel la couche d'isolant de grille inférieure (43) se termine à fleur des régions inférieures (33) des piliers (30).

8. Dispositif à semi-conducteur de puissance (1) selon l'une quelconque des revendications précédentes,
dans lequel les piliers (30) présentent chacun la forme d'un cône tronqué, et
dans lequel un angle d'ouverture des cônes tronqués est compris entre 10° et 35° inclus.

9. Procédé de fabrication d'un dispositif à semi-conducteur de puissance (1, 1*), comprenant :
A) la fourniture d'un substrat semi-conducteur (51, 61),
B) la fourniture d'un masque semi-conducteur (63) sur le substrat semi-conducteur (51, 61) pour des piliers (30) d'un empilement de couches semi-conductrices (3),
C) la formation de tubes (64) en un matériau isolant au niveau de parois latérales du masque semi-conducteur (63), et
D) la croissance des piliers (30) comprenant du SiC dans les tubes (64), dans lequel
- les tubes (64) sont maintenus dans le dispositif à semi-conducteur de puissance (1) fini,
- le procédé comprend en outre la fourniture d'une première électrode principale (21) et d'une deuxième électrode principale (22), l'empilement de couches semi-conductrices (3) étant entre et en contact avec la première électrode principale (21) et la deuxième électrode principale (22),
- le procédé comprend en outre la fourniture d'une couche d'électrode de grille (4) entre la première électrode principale (21) et la deuxième électrode principale (22),
- l'empilement de couches semi-conductrices (3) comprend une pluralité de piliers (30) en contact avec la première électrode principale (21), et les piliers (30) traversent la couche d'électrode de grille (4),
- l'ensemble de l'empilement de couches semi-conductrices (3) est du même type de conductivité au moins par endroits depuis la première électrode principale (21) jusqu'à la deuxième électrode principale (22),
- chacun des piliers (30) comprend une région supérieure (31) au niveau de la première électrode principale (21) avec une première concentration de dopage,
- sur des côtés des régions supérieures (31) orientés à l'opposé de la première électrode principale (21), et dans un plan commun (P) avec la couche d'électrode de grille (4), chacun des piliers (30) comprend une région de canal (32) avec une deuxième concentration de dopage, et
- la première concentration de dopage dépasse la deuxième concentration de dopage d'au moins un facteur 10,
et dans lequel soit l'étape de procédé B) comprend les sous-étapes suivantes :
B1) la croissance d'une couche de départ continue (62),
B2) la structuration de la couche de départ continue (62) de manière à fournir le masque semi-conducteur (63), le masque semi-conducteur (63) étant un positif des piliers,
dans lequel le masque semi-conducteur (63) est complètement éliminé après l'étape C) et avant l'étape D),
dans lequel, à l'étape D), les piliers (30) sont formés par croissance sélective dans les tubes (64) et un espace entre des tubes adjacents (64) est exempt de tout matériau solide à l'étape D), et
dans lequel l'étape D) est suivie de l'étape E) :
E) la réalisation de la couche d'électrode de grille (4) entre les piliers (30),
soit, à l'étape de procédé B), le masque semi-conducteur (63) est fourni sous la forme d'un négatif des piliers (30),
dans lequel, après l'étape C), un espace entre des tubes adjacents (64) est rempli par au moins un matériau de remplissage (65) ou par au moins un matériau semi-conducteur supplémentaire (68) à une étape C1),
dans lequel, entre les étapes C1) et D), le masque semi-conducteur (63) est éliminé, et
dans lequel le masque semi-conducteur (63) est complètement éliminé après l'étape C) et avant l'étape D).

10. Procédé selon la revendication 9,
dans lequel le substrat semi-conducteur (51, 61) est un substrat en Si,
dans lequel le substrat semi-conducteur (51, 61) est éliminé après l'étape D).
